(19) Europäisches Patentamt
European Patent Office
Office européen des brevets

(11) EP 1 452 566 A1

(12) **EUROPEAN PATENT APPLICATION**
published in accordance with Art. 158(3) EPC

(43) Date of publication:
**01.09.2004 Bulletin 2004/36**

(21) Application number: **02730720.6**

(22) Date of filing: **27.05.2002**

(51) Int Cl.[7]: **C08L 101/00**, C08L 23/30, C08L 63/00

(86) International application number:
**PCT/JP2002/005114**

(87) International publication number:
**WO 2003/000798 (03.01.2003 Gazette 2003/01)**

(84) Designated Contracting States:
**AT BE CH CY DE DK ES FI FR GB GR IE IT LI LU MC NL PT SE TR**

(30) Priority: **25.05.2001 JP 2001156614**
**06.07.2001 JP 2001205646**

(71) Applicant: **Nippon Petrochemicals Company, Limited**
**Tokyo 100-8530 (JP)**

(72) Inventors:
- **TAKASHIMA, Tsutomu**
  **Kawasaki-shi, Kanagawa 211-0051 (JP)**
- **FUJIMURA, Kouji**
  **Kisarazu-shi, Chiba 292-0815 (JP)**
- **NOMURA, Hideki**
  **Yokohama-shi, Kanagawa 224-0004 (JP)**

(74) Representative: **Strehl Schübel-Hopf & Partner**
**Maximilianstrasse 54**
**80538 München (DE)**

(54) **THERMOSETTING RESIN COMPOSITION, PROCESS FOR PRODUCING THE SAME, AND SUSPENSION-FORM MIXTURE**

(57) This invention relates a thermosetting resin composition which is produced by curing a composition containing a thermosetting resin and a reactive mono-olefin polymer, and its phase structure is sea-island structure which comprises a continuous phase mainly composed of a cured composition containing a thermosetting resin and, if necessary, further curing agent and dispersed phases mainly composed of a reactive mono-olefin polymer and said dispersed phases contain a plurality of finer dispersed phases and/or at least one layer of interfacial phases surrounding said dispersed phases, thereby providing a thermosetting resin composition that is suitable for use in sealing or encapsulating semiconductor devices, which composition has improved impact strength, resistance to thermal cracking, resistance to deterioration by oxidation, without losing thermal stability.

FIG. 2

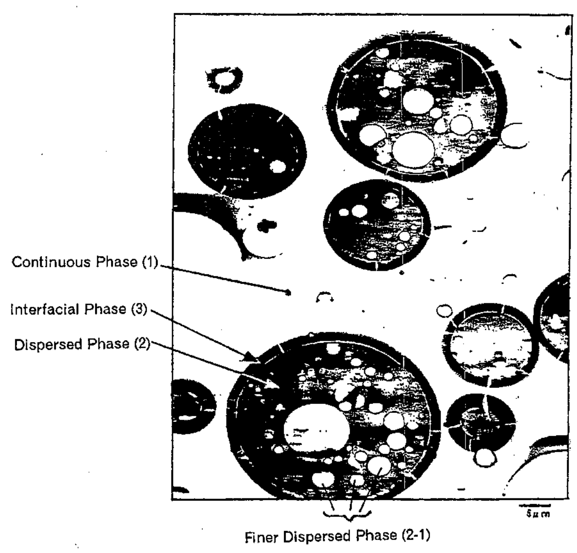


EP 1 452 566 A1

## Description

TECHNICAL FIELD

The present invention relates to the improvement in impact strength of a thermosetting resin composition. More particularly, the invention provides an epoxy resin composition that is used for sealing or encapsulating semiconductor devices, which resin composition is improved in impact strength, resistance in thermal cracking test, resistance to deterioration caused by heat or oxidation.

BACKGROUND ART

Thermosetting resin is used singly or in combination with other resins, for various purposes. Especially, it is widely used for producing various parts of electrical appliances and machinery taking the advantages of its excellent electrically insulating property, high mechanical strength, high thermal stability, low coefficient of thermal expansion and inexpensiveness. However it has a serious disadvantage of poor toughness or tenacity that is common among other thermosetting resins. Accordingly, various attempts have been made in order to solve the problem of this kind.

In addition to the above problem, it is demanded to reduce the volume shrinkage of thermosetting resin during the curing because it causes some troubles. The problems due to the large volume shrinkage are exemplified by the lack of surface smoothness of SMC (sheet molding compound) products, the low adhesiveness to coating film or lining finish and the deformation of FRP (fiber reinforced products) that is caused by differences in shrinkage of various component parts.

For example, in order to improve the impact strength of epoxy resin, one of thermosetting resins, it is well known as effective to introduce a flexible component into the epoxy resin and to use rubber particles having core-shell structure (Japanese Patent Publication No. S61-42941, Japanese Laid-Open Patent Publication No. H2-117948), to add reactive liquid rubber (Japanese Patent Publication No. S58-25391, Japanese Laid-Open Patent Publication No. H10-182937 and Japanese Patent No. 3036657) and to reactive liquid polybutene (European Patent Publication No. 0415749). However, several problems in these methods have been revealed.

For example, in a method to add a flexible component to epoxy resin, thermal stability and mechanical property such as bending strength are deteriorated. If rubber particles having a core-shell structure such as MBS powder (methyl methacrylate-styrene-butadiene copolymer particles in core-shell structure), fine rubber particles such as composite acrylic rubber particles containing epoxy groups, or cross-linked acrylic rubber particles are blended, the viscosity is largely increased and the storage stability is impaired.

In the method of blending reactive liquid rubber, such as terminal carboxyl group-modified acrylonitrile-butadiene rubber (CTBN), the above-mentioned troubles may scarcely occur. In the case of epoxy resin composition containing CTBN, the CTBN, which is dissolved in epoxy resin in the initial stage is separated out from the phase of epoxy resin with the progress of curing to form a dispersed phase. The dispersed phase forms a sea-island structure which consist of continuous phase of cured epoxy resin composition and a dispersed phase of CTBN, and the impact strength can be improved owing to this phase structure. On the other hand, when CTBN is involved within the continuous phase of epoxy resin, the thermal stability, that is typically indicated by heat distortion temperature (HDT), is degraded. In other words, the control of reactivity and affinity of CTBN due to its chemical structure cannot satisfactorily be attained, so that the particle size and the distribution of dispersed CTBN phase are varied with the kind of curing agent and curing conditions. As a result, the characteristic properties of epoxy resin composition is varied. Moreover, it is well known that essential problems in long-term stability such as the degradation by oxidation or heat is caused to occur because CTBN has unsaturated bonds in its main chains.

A liquid rubber-modified epoxy resin that is made by modifying epoxy resin with CTBN was proposed in recent years (Japanese Laid-Open Patent Publication No. 2001-089638). In this resin, however, the similar problem has not been resolved sufficiently.

In European Patent Publication No. 0415749 (U.S. Patent Nos. 5,084,531 and 5,225,486), it is proposed to epoxidize liquid polybutene having substantially no unsaturated bond in the main chains and to improve the impact strength of epoxy resin composition by using the epoxidized liquid polybutene. In this method, epoxidized liquid polybutene having a molecular weight preferably in a range of 200 to 400 and poly-amino-amide as a curing agent are used. Thereby, suppressing the generation of phase separation structure (sea-island structure) in the obtained epoxy resin composition as being described "The mixture is then combined with the epoxy resin." and "upon examination under an electron microscope, the presence of epoxidized polybutene droplets could not be discerned in epoxy resin containing epoxidized polybutene".

In this method, it is recommended that the structure and position of unsaturated bonds of polybutene used for epoxidizing are composed of 70 molar % of tetra-substituted structure. This means to recommend the use of polybutene raw material, which has unsaturated bonds existing not at molecular terminals but in main chains. Accordingly,

it is naturally supposed that epoxy groups are generated in the main chains of epoxidized polybutene.

It is apparent that the reactivity of epoxy groups in main chains is inferior to the reactivity of those at terminals of molecules. Furthermore, it may easily be supposed that their reactivity lowers with the increase of molecular weight. Therefore, in this method, it is difficult to use liquid epoxidized polybutene having relatively high molecular weight, so that it is considered that the use of relatively low molecular weight liquid epoxidized polybutene is recommended.

In accordance with this proposal, the liquid epoxidized polybutene of low molecular weight is supposed to combine with the epoxy resin through epoxy groups existing in its middle part of main chain. Accordingly, the length of polybutene chain connected to epoxy resin is very short. Therefore, with such a structure, it is difficult to form the phase separation structure (sea-island structure). As described above, in view of the heat stability represented by HDT, the method of improving impact strength by enhancing flexibility of cured epoxy resin composition in continuous phase is inferior to the improvement by means of the phase separation structure.

In this method, because liquid epoxidized polybutene containing 70 molar % of tetra-substituted structure is produced, the probability of the existence of tertiary carbon atoms in the main chain is high. Therefore, the deterioration owing to oxidation or to heat is liable to occur and there is a room for improving the long-term reliability.

On the other hand, phenol resin has been used singly or in combined with other resins for various purposes. Especially it has been used for producing various parts of electrical appliances and machine parts with the advantages of its excellent electrically insulating property, high mechanical strength, large thermal stability, low thermal expansion coefficient, good flame retardant property and its inexpensiveness. However, its inferior in toughness that is a common defect among thermosetting resins and this fact is a most serious problem in the phenol resin. So that, several attempts for resolving this problem has been made from various viewpoints.

For example, proposed in Japanese Laid-Open Patent Publication No. S61-168652 is an improvement in impact strength of specific phenol resin by using aromatic polyester, and in Japanese Laid-Open Patent Publication No. S62-209158, an improvement in toughness of phenol resin by using specific polyethylene terephthalate, polyurethane and methyl methacrylate copolymer. However these methods were not satisfactory because the improvement in toughness is insufficient or the fluidity of resin is impaired.

In connection with phenol resin, the improvement by using reactive liquid rubber has also been intended widely. For example, a method of kneading emulsion polymerized latex of rubber having functional group such as epoxy group, hydroxyl group, carboxyl group or amino group with phenol resin is proposed in Japanese Laid-Open Patent Publication No. S62-59660. In a method as disclosed in Japanese Laid-Open Patent Publication No. H3-17149, an anionic surface-active agent is added to conjugated diene type rubber latex such as NBR that is highly compatible with phenol resin, the mixture is dispersed into phenol resin before the dehydration step of the resin. Furthermore, it is disclosed in Japanese Laid-Open Patent Publication No. H3-221555 that the epoxidized polybutadiene and radical polymerization initiator are added to molding material in the kneading step. In these methods, although it is possible to improve the toughness of phenol resin when rubber is added sufficiently to impart toughness, the fluidity is seriously lowered, so that the practical moldability is impaired and the thermal stability of phenol resin is lost.

The present invention provides thermosetting resin compositions such as those of epoxy resin and phenol resin, which are suitable for use in sealing or encapsulating semiconductors and so forth. The resin compositions have improved properties in impact strength, thermal cracking resistance, resistance to oxidation degradation and to thermal deterioration without losing thermal stability as typically represented by HDT.

Furthermore, the thermosetting resin composition of the present invention is low in the ratio of volume shrinkage, and it solved the problems in the surface smoothness of products of SMC (sheet molding compound), adhesiveness or coating strength of coating film and lining finish and the deformation of FRP that is caused by the differences in volume shrinking of component parts.

## DISCLOSURE OF INVENTION

The inventors accomplished this invention by finding out that above mentioned problems can be resolved by using a high impact strength thermosetting resin composition with a phase structure of a sea-island structure mainly composed of a continuous phase and dispersed phases, having plural finer dispersed phases inside the former dispersed phases and/or at least one interfacial phase surrounding around the former dispersed phases. In this phase structure, the continuous phase is mainly composed of a cured composition containing thermosetting resin and the dispersed phases are mainly composed of reactive mono-olefin polymer having functional groups with an ability to react with the thermosetting resin or the curing agent.

In the method for preparing a high impact strength thermosetting resin composition, the inventors also found out that above-mentioned phase structure can effectively be formed by employing a step to prepare a suspension by mixing a part of component selected from a thermosetting resin, a curing agent, and if necessary, a curing accelerator with reactive mono-olefin polymer, hereinafter referred to as "liquid suspension mixture". The high impact strength thermosetting resin composition is produced by curing a composition composed of a thermosetting resin, curing agent,

reactive mono-olefin polymer modified by functional groups with an ability to react with the thermosetting resin or the curing agent (hereinafter referred to as "reactive mono-olefin polymer").

That is, a first aspect of the present invention relates to a high impact strength thermosetting resin composition having a phase structure of a sea-island structure essentially consists of a continuous phase (1) mainly composed of a cured composition containing thermosetting resin and dispersed phases (2) mainly composed of reactive mono-olefin polymer having functional groups with an ability to react with the thermosetting resin, said dispersed phase (2) including plurality of finer dispersed phases (2-1) within the dispersed phases, and/or having at least one interfacial phase (3) which surrounds around the dispersed phases (2).

A second aspect of the present invention relates to a method for preparing a high impact strength thermosetting resin composition, which is produced by curing a composition composed of a thermosetting resin (A), curing agent (B) and reactive mono-olefin polymer (C) modified by functional groups with an ability to react with the thermosetting resin or the curing agent, having a phase structure of a sea-island structure mainly composed of a continuous phase (1) and dispersed phases (2), including a plurality of finer dispersed phases (2-1) within the dispersed phases (2), and/or having at least one interfacial phase (3) surrounding around the dispersed phases (2), wherein the method of preparation contains a step to prepare a liquid suspension mixture of the reactive mono-olefin polymer (C), a thermosetting resin (A), and if necessary, curing agent (B).

A third aspect of the present invention relates to the method for preparing a high impact strength thermosetting resin composition according to the second aspect of the invention, wherein the liquid suspension mixture contains 1 to 200 parts by mass of the reactive mono-olefin polymer (C) relative to 100 parts by mass of the thermosetting resin (A), in the case that the curing agent (B) is not contained.

A fourth aspect of the present invention relates to the method for preparing a high impact strength thermosetting resin composition according to the second aspect of the invention, in which the liquid suspension mixture contains thermosetting resin (A), curing agent (B) and reactive mono-olefin polymer (C), and the mixture contains 1 to 100 parts by mass of the reactive mono-olefin polymer (C) relative to 100 parts by mass of components (A) + (B) having a ratio of functional group equivalent (g/eq.) as (A)/(B) of 5 or more.

A fifth aspect of the present invention relates to the method for preparing a high impact strength thermosetting resin composition according to the second aspect of the invention containing thermosetting resin (A), curing agent (B) and reactive mono-olefin polymer (C), wherein the liquid suspension mixture contains 1 to 100 parts by mass of the reactive mono-olefin polymer (C) relative to 100 parts by mass of the components (A) + (B) having a ratio of functional group equivalent (g/eq.) as (A)/(B) of 0.2 or less.

A sixth aspect of the present invention relates to the method for preparing a high impact strength thermosetting resin composition according to the second aspect of the invention, wherein the thermosetting resin (A) is composed of an epoxy resin or a phenol resin.

A seventh aspect of the present invention relates to the method for preparing a high impact strength thermosetting resin composition according to any one of the second aspect to the sixth aspect of the invention, wherein the functional groups of the reactive mono-olefin polymer (C) is at least one member selected from the group consisting of the following (a) to (f).

(a) Oxirane group,
(b) Hydroxyl group,
(c) Acyl group,
(d) Carboxyl group (including acid anhydride group),
(e) Amino group, and
(f) Isocyanate group

A eighth aspect of the present invention relates to the method for preparing a high impact strength thermosetting resin composition according to any one of the second aspect to the seventh aspect of the invention, wherein the reactive mono-olefin polymer (C) has 80 molar % or more of repeating unit in the main chain of the chemical structure that is represented by the following formula (I).

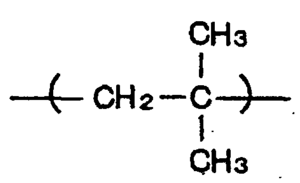 ..... ( I )

A ninth aspect of the present invention relates to the method for preparing a high impact strength thermosetting resin composition according to any one of the second aspect to the eighth aspect of the invention, wherein the reactive mono-olefin polymer (C) has functional groups that are positioned substantially at terminals of molecules.

A tenth aspect of the present invention relates to the method for preparing a high impact strength thermosetting resin composition according to any one of the second aspect to the ninth aspect of the invention, wherein the reactive mono-olefin polymer (C) has a number average molecular weight in the range of 300 to 6000.

A eleventh aspect of the present invention relates to the method for preparing a high impact strength thermosetting resin composition according to any one of the second aspect to the tenth aspect of the invention, wherein the reactive mono-olefin polymer (C) is in liquid state at 23 °C.

A twelfth aspect of the present invention relates to a liquid suspension mixture, which contains thermosetting resin (A) and reactive mono-olefin polymer (C) modified by functional groups that are reactive with the thermosetting resin (A) and contains no curing agent (B), wherein the liquid suspension mixture is composed of 1 to 200 parts by mass of (C) relative to 100 parts by mass of the component (A).

A thirteenth aspect of the present invention relates to a liquid suspension mixture, which contains a thermosetting resin (A), curing agent (B) and reactive mono-olefin polymer (C) that is modified by functional groups that are reactive with the thermosetting resin (A) or with the curing agent (B), wherein the liquid suspension mixture contains 1 to 100 parts by mass of the reactive mono-olefin polymer (C) relative to 100 parts by mass of components (A) + (B) having a functional group equivalent (g/eq.) as (A)/(B) of 5 or more.

A fourteenth aspect of the present invention relates to a liquid suspension mixture, which contains thermosetting resin (A), curing agent (B) and reactive mono-olefin polymer (C) modified by functional groups that are reactive with the thermosetting resin (A) or the curing agent (B), wherein the liquid suspension mixture contains 1 to 100 parts by mass of the reactive mono-olefin polymer (C) relative to 100 parts by mass of components (A) + (B) having a functional group equivalent (g/eq.) as (A)/(B) of 0.2 or less.

In the following, the present invention is described in more detail.

In the first place, the first aspect of the present invention is explained.

In the thermosetting resin composition of the present invention, it is possible to suppress the lowering of thermal stability that is represented by heat distortion temperature (HDT) and to improve impact strength or resistance to thermal cracking by employing a phase structure of a sea-island structure. The structure is mainly composed of a continuous phase (1) composed of a cured thermosetting resin and a dispersed phases (2) mainly composed of reactive mono-olefin polymer, and finer dispersed phases (2-1) exist within the dispersed phases (2) (hereinafter referred to as "Phase Structure I"). It also possible to carried out with a phase of a sea-island structure mainly composed of a continuous phase (1) and dispersed phases (2), in which interfacial phases (3) surround the dispersed phases (hereinafter referred to as "Phase Structure II"). Furthermore, it is possible to form a combined phase structure composed of the above structures.

These phase structures have not been known in the prior art thermosetting resin compositions. The details in the mechanism of their formation will be described.

A well known phase structure of this kind contains dispersed phase of several μm in particle size and is mainly composed of elastic and tough rubbery component with a low elastic modulus, that are dispersed in a continuous phase that is mainly composed of a cured composition containing thermosetting resin of high elastic modulus but brittle. When this phase structure is deformed by stress, the force of exfoliation is caused to occur by the difference in Poisson's ratios of constituent materials of continuous phase (1) and dispersed phases (2) and the interfacial exfoliation of both phases is caused to occur. It is supposed that the stress (distortion) is consumed (released) by the interfacial exfoliation and the fatal breakage of crack is not caused to occur in the continuous phase, so that, it is possible to improve the impact strength and thermal cracking resistance.

In Phase Structure I, the continuous phase (1) is mainly composed of cured material containing a thermosetting resin of brittle and of high elastic modulus, and if necessary, curing agent is added. In the continuous phase (1), particles of dispersed phase (2) having a particle size of several μm and mainly composed of an elastic and tough reactive mono-olefin polymer of low elastic modulus, are dispersed. Furthermore, finer dispersed phases (2-1) exist in the particles of the dispersed phase (2). (The finer dispersed phase is also mainly composed of cured material containing a thermosetting resin or further curing agent). This phase structure is observed in high impact strength polystyrene and ABS resin and called as "salami structure", however, it has not been realized in thermosetting resin composition.

When deformation is caused to occur in Phase Structure I by stress, also in the dispersed phases (2), the stress (distortion) is consumed (released) by the exfoliation in the interfaces of the finer phases (2-1), in addition to the occurrence in the general sea-island structure. Accordingly, interfacial exfoliation energy per unit volume is larger. Furthermore, the adhesive strength between continuous phase (1)/dispersed phase (2) or dispersed phase (2)/finer dispersed phase (2-1) is large owing to the chemical interaction of reactive mono-olefin polymer with thermosetting resin and/or curing agent. Accordingly, consumed energy by the exfoliation of this phase is larger than that in ordinary

structure consisting of continuous phase and dispersed phase.

Therefore, the fatal breakage of cracking is not caused to occur in the continuous phase, so that the impact strength and thermal cracking resistance can effectively be improved.

Phase Structure II is composed of the continuous phase (1), the dispersed phases (2) of several μm in a particle size that are dispersed in the continuous phase (1) and interfacial phases (3) of several μm in thickness, which surrounds the dispersed phases (2). The continuous phase (1) is brittle with a high elastic modulus and mainly composed of cured composition containing thermosetting resin, and if necessary, a curing agent is added. The dispersed phases (2) are mainly composed of the reactive mono-olefin polymer which is elastic and tough material with a low elastic modulus and the interfacial phases (3) are mainly composed of a material produced by the reaction between the cured material of thermosetting resin, and if necessary, curing agent and reactive mono-olefin polymer, which is an elastic and tough material with a low elastic modulus. This phase structure has been observed in the structure of high impact strength polypropylene (block type polypropylene), the so-called multilayer structure. In the thermosetting resin composition, the structure has not been realized. That is, in the high impact strength polypropylene, the dispersed phase of polyethylene exists in the continuous phase of polypropylene with interfacial phase of ethylenepropylene copolymer rubber that surrounds the dispersed phase.

When Phase Structure II is deformed by stress, the stress (distortion) is also consumed (released) by the spreading of exfoliation in both sides of interfacial phases (3). Accordingly, the interfacial exfoliation energy per unit volume is larger than that of ordinary sea-island structure. The adhesive strength between the continuous phase (1) and the interfacial phase (3), and the interfacial phase (3) and the dispersed phase (2), are large owing to the chemical interaction of reactive mono-olefin polymer with the thermosetting resin and the curing agent. Accordingly, consumed energy by the exfoliation of this phase is larger than that of ordinary structure consisting of continuous phase and dispersed phase.

Therefore, the fatal breakage of cracking is not caused to occur in the continuous phase so that the impact strength and thermal cracking resistance can effectively be improved.

In the case of phase structure which can meet both the Phase Structure I and Phase Structure II, finer dispersed phase (2-1) of several μm in diameter exists inside the dispersed phase (2) and interfacial phase (3) of several μm in thickness surrounds the dispersed phase (2), besides the dispersed phase (2) exists in continuous phase (1). This continuous phase (1) is mainly composed of cured material containing thermosetting resin, and if necessary, curing agent, which is a brittle material with a high elastic modulus. The dispersed phase (2) is mainly composed of reactive mono-olefin polymer of an elastic and tough material with a low elastic modulus. And the finer dispersed phase (2-1) is mainly composed of a cured material containing thermosetting resin, or further curing agent. The interfacial phase (3) is mainly composed of a product between reactive mono-olefin polymer and cured material containing thermosetting resin that is an elastic and tough material with a low elastic modulus. In this phase, consumed energy by the exfoliation is still larger than that of Phase Structure I or Phase Structure II.

Therefore, the fatal breakage of cracking is not caused to occur in the continuous phase so that the impact strength and thermal cracking resistance can effectively be improved. Such a phase structure as the above has not yet been realized even in thermoplastic resin composition.

It is considered that the effect of decrease in volume shrinkage ratio of thermosetting resin composition of the present invention is dependent upon the low volume shrinkage ratio of reactive mono-olefin polymer and chemical interaction with the thermosetting resin. It is also considered that the foregoing structure of Phase Structure I and/or Phase Structure II contributes not only to the stress releasing when impact is applied but also to the lowering of the volume shrinkage at the curing process.

The phase structure of the present invention will be described in comparison with the prior art ones.

(i) In the structure of thermosetting resin composition which is made by combining a flexible component without forming the sea-island structure, the stress of deformation is consumed by whole elastic deformation of the material. Accordingly, the flexibility and thermal stability of the whole composition are in the contrary relationship, which causes problems in thermal stability.

In the phase structure of the present invention, the above-mentioned problems can be solved through imparting the thermal stability by forming continuous phase, which is mainly composed of cured material containing thermosetting resin or further adding a curing agent, and by consuming the stress (distortion) by interfacial exfoliation of the specific sea-island structure.

(ii) In the structure of thermosetting resin composition obtained by blending rubber particles having core-shell structure, the distortion by stress is only consumed by the interfacial exfoliation between continuous phase, which is mainly composed of cured composition containing thermosetting resin or further adding a curing agent, and rubber particles having core-shell structure. Accordingly, in order to form sufficient amount of interfacial phases per unit volume, it is necessary to introduce by crosslinking a large quantity of rubber particles with core-shell structure of about one μm in diameter, into prepolymer. This inevitably causes the serious increase in viscosity of

the composition. For dispersing the rubber particles uniformly, it is necessary to modified chemically the outer layers of rubber particles of core-shell structure, so that the manufacturing process may become complicated. The interfacial exfoliation of the outer layers of the chemically modified rubber particles does not caused to occur, so that, the consumption of distortion energy depends only upon the exfoliation of interfacial phases between the rubber particles of core-shell structure and the continuous phase which is mainly comprised of cured material containing thermosetting resin or further curing agent.

The present invention can solve the above problem by consuming the energy of distortion through interfacial phases between the dispersed phase and finer dispersed phases existing in the former dispersed phase and by modifying chemically the main component of the dispersed phase.

In the following, the first aspect of the present invention is described in more detailed together with the second aspects and so forth.

The thermosetting resin (A) of the present invention means the resin that, in the initial stage, it is usually a liquid low molecular weight compound (sometimes called as "pre-polymer"), and it is then cross-linked by chemical reaction by the action of heat, catalyst or ultraviolet rays to form a three-dimensional network structure of high molecular weight compound. Therefore, it is not always necessarily to heat it for curing. It is typically exemplified by phenol resin, urea resin, melamine resin, epoxy resin, polyurethane, silicone resin, alkyd resin, allyl resin, unsaturated polyester resin, diallyl phthalate resin, furan resin and polyimide.

Concerning the phenol resin in thermosetting resin (A) of the present invention, there is no limitation and commercially available products can be used. It can be obtained by heating a phenolic compound and formaldehyde at a molar ratio in a range of 0.5 to 1.0 in the presence of a catalyst such as oxalic acid, hydrochloric acid, sulfuric acid or toluenesulfonic acid, refluxing them to react for a suitable period of time, subjecting the reaction product to vacuum dehydration or gravity settling (decantation) for removing water, and further eliminating remained water and unreacted phenol compounds. These resins or co-condensation phenol resin produced by using plurality of raw materials can be used singly or in combination of two or more resins. The resol-type phenol resin can also be used likewise by controlling the thermal history in mixing.

Concerning the epoxy resin used as the thermosetting resin (A) of the present invention, there is no limitation in property, epoxy equivalent, molecular weight and molecular structure. The compound containing two or more oxirane rings in the molecule can be used, that is, various well-known epoxy resins can be used.

The epoxy resins are exemplified by bisphenol A type resin, bisphenol F type resin, brominated bisphenol A type resin, glycidyl ether type epoxy resin such as novolak glycidyl ether type, glycidyl ester type epoxy resin such as glycidyl hexahydrophthalate and dimeric glycidyl ester, glycidyl amine type epoxy resin such as triglycidyl isocyanurate and tetraglycidyl diamino diphenylmethane, linear aliphatic epoxy resin such as epoxidized polybutadiene and epoxidized soybean oil, and alicyclic epoxy resin such as 3,4-epoxy-6-methylcyclohexyl methyl carboxylate and 3,4-epoxycyclohexyl methyl carboxylate. It is possible to use one of them singly or two or more of them.

An epoxy resin that is in liquid at ordinary temperatures is preferably used. The glycidyl ether type epoxy resin is exemplified, which is produced by reacting epichlorohydrin and an aromatic compound having one or more hydroxyl group under alkaline condition. More particularly, bisphenol A type epoxy resin, Epikote #828 as a commercially available product (made by Japan Epoxy Resins Co., Ltd.) is exemplified.

As the curing agent (B), any material that can react with and can cure the thermosetting resin may be used.

In the case of epoxy resin as the thermosetting resin, curing agents are exemplified by aliphatic polyamine, alicyclic polyamine, aromatic polyamine, acid anhydrides (e.g., methyl-hexahydrophthalic anhydride, and phthalic anhydride derivative), phenolic novolak resin, polyaddition-type curing agent such as polymercaptan, aromatic tertiary amine, imidazole compounds, and catalytic curing agent such as Lewis acid complex. Above curing agents can be used singly or in a mixture with other curing agent as far as the mixture does not produce any undesirable result.

In addition to the thermosetting resin (A) and the curing agent (B), a curing accelerator can be used if necessary. In the case of epoxy resin as the thermosetting resin, it is exemplified by amine compounds such as benzyl dimethylamine (BDMA), 1-benzyl-2-phenylimidazole, 2-heptadecylimidazole, 2-phenyl-4,5-dihydroxyimidazole, 2-phenyl-4-methyl-5-hydroxymethyl imidazole, 2,4-diamino-6-[2,methylimidazolyl-(1)]-ethyl-s-triazine, 1-cyanoethyl-2-undecylimidazole, 2-ethyl-4-methylimidazole, 1,8-diazabicyclo[5,4,0]-undecene-7 and their salts; phosphine compounds such as triphenylphosphine and tris(2,6-dimethoxyphenyl)phosphine and their salts; and/organometallic salt such as tin octylate.

In the present invention, a reactive mono-olefin polymer (C) which is chemically modified by functional group having ability to react with the thermosetting resin (A) or the curing agent (B) is used. This polymer is hereinafter referred to as "reactive mono-olefin polymer". The reactive mono-olefin polymer is a chemically modified polymer or a copolymer of mono-olefin by addition reaction of functional group having an ability to react with the thermosetting resin or the curing agent. The mono-olefin is exemplified by $\alpha$-olefins having 36 or less carbon atoms such as ethylene, propylene, butene, isobutene, butene-2, pentene-1, pentene-2, isoprene, hexane-1 and 4-methylpentene.

The method of chemical modification is not limited and it is exemplified by addition reaction in the presence of organic peroxide, addition reaction to the unsaturated carbon bonds of mono-olefin polymer and epoxidizing of the unsaturated carbon bonds of mono-olefin polymer.

As the functional group, there are exemplified by (a) oxirane (epoxy) group, (b) hydroxyl group, (c) acyl group, (d) carboxyl group (including acid anhydride group), (e) amino group and (f) isocyanate group because these groups can easily react with the thermosetting resin or the curing agent.

The reactive mono-olefin polymer of the present invention is used intact by obtaining a highly pure product or it is used as a mixture with another ordinary mono-olefin polymer.

In the preparing method of the composition having foregoing phase structure, it is necessary to employ the following step before obtaining the final cured composition with high impact strength, which is composed of thermosetting resin (A), curing agent (B) and reactive mono-olefin polymer (C).

That is, the thermosetting resin (A) and the curing agent (B), and if necessary one member selected from curing accelerators, are mixed with the reactive mono-olefin polymer (C) to form a finely dispersed phase (liquid suspension mixture) mainly composed of the reactive mono-olefin polymer in the liquid suspension mixture (When the reactive mono-olefin polymer is solid, this means the step to dissolve it.)

This suspended state means that, after the mixing, the suspension does not substantially change its suspension state under the conditions of mixing process for one day or longer, more preferably the suspension is not changed for one month or more.

It can be confirmed by electron microscopic observation concerning the phase structure that the main portion consists of plurality of finely dispersed phase and/or at least one layer of interfacial phase surrounds all the respective particles of the dispersed phase.

The above-mentioned procedure provides, before the curing, the condition which contribute to form the phase structure that is preferable for the improvement of impact strength of the final thermosetting resin composition.

Although the reason why the stable suspended state can be formed, is not clearly known, it is considered that the chemical reaction product of dissolved reactive mono-olefin polymer (C) with the thermosetting resin (A), and/or dissolved reactive mono-olefin polymer (C) with the curing agent (B) exerts the function like a surface-active agent in the mixture.

Furthermore, the liquid suspension mixture can easily be obtained by maintaining the compounding ratios of the respective components such as the relation of functional group equivalent (g/eq.) of each component is set into the following specific range. The functional group equivalent (g/eq.) herein referred to means the epoxy equivalent (g/eq.) in the case of the thermosetting resin is an epoxy resin, while it means the active hydrogen equivalent (g/eq.) in the case of a phenol resin. Similarly, it means acid anhydride group equivalent (g/eq.) in the case of an acid anhydride curing agent and amino group equivalent (g/eq.) in the case of an amine curing agent. Furthermore, it is possible to indicate in terms of a total amount of reactive functional group equivalent (g/eq.) when several functional groups coexist.

The ratio of functional group equivalents (g/eq.) of the thermosetting resin (A) to the curing agent (B), as represented by (A)/(B), is 5 or more, preferably 10 or more but not more than 200. Otherwise, the ratio of (A)/(B) may not be more than 0.2, preferably not more than 0.1 but not less than 0.001. As described above, the liquid suspension mixture of the present invention can be obtained by preparing a mixture containing components (A) and (B) with excess amount of either one of them. That is, the liquid suspension mixture of the invention can be prepared by mixing 1 to 100 parts by mass of reactive mono-olefin polymer (C) into 100 parts by mass of the above mixture of (A) and (B). The ratio (A)/(B) of an ordinary thermosetting resin composition is generally in the range of 0.5 to 1.5, however, the composition of the invention can be prepared by using a large excess amount of either one of components in the step of preparing the liquid suspension mixture.

When the ratio of (A)/(B) is less than 5 but more than 0.2, although it is possible to form the above-mentioned structure in a final product, the viscosity of liquid suspension mixture increases markedly, which is not suitable for practical processing. If 100 parts by mass or more of the reactive mono-olefin polymer (C) is used relative to 100 parts by mass of the liquid suspension mixture, the viscosity of the liquid suspension mixture increases markedly like the above-mentioned case.

When the curing agent (B) is not used, 1 to 200 parts by mass of the reactive mono-olefin polymer (C) must be used to 100 parts by mass of the thermosetting resin (A). When more than 200 parts by mass of the reactive mono-olefin polymer (C) is used relative to 100 parts by mass of the thermosetting resin (A), the viscosity of the liquid suspension mixture itself increase markedly, which is not suitable for practical uses in the like manner as the above.

The temperatures, time lengths and methods of adding respective components for preparing the liquid suspension mixture are not especially limited. There is no limitation in the method of stirring the components as far as uniform mixing can be attained. In the case that a specific size of dispersed particles is required, it is desirable to control by using a forced stirrer such as homogenizer.

The liquid suspension mixture as described above can contribute to the formation of a preferable phase structure with high impact strength in a succeeding step of producing final thermosetting resin composition.

In order to produce the thermosetting resin composition of high impact strength in this final step, the thermosetting resin composition(A) and/or the curing agent (B), and if necessary, a curing accelerator are supplemented to the preceding liquid suspension mixture so as to adjust the final ratio of functional group equivalent of (A) to (B) in a range of 0.2 to 5.0, preferably 0.5 to 1.5.

The thermosetting resin composition of the present invention having specific sea-island structure can be obtained by curing the composition through a suitable means such as heating, addition of catalyst or irradiation with ultraviolet rays after the ratios of reactant materials are adjusted into appropriate ranges.

In the use of the obtained composition for various practical purposes, in addition to the above mentioned components, well-known liquid reactive rubber, liquid rubber such as liquid $\alpha$-olefin polymer, elastomer, impact resistance improver such as core-shell structure elastomer; flame retardant, coupling agent, deforming agent, pigment, dye stuff, antioxidant, weatherproof agent, fillers such as lubricant and releasing agent can be blended appropriately as far as the effect of the present invention is not impaired.

The fillers are exemplified by fused silica, crushed silica, talc, calcium carbonate, aluminum hydroxide and the like. Among them, the fused silica having an average particle size of less than 20 $\mu$m is desirable in the use for sealing or encapsulating semi-conductors that is demanded in recent years. These additives can be used singly or in combination with two kinds or more.

As the reactive mono-olefin polymer (C) which is described in the foregoing passage, it is exemplified by a liquid polybutene as a preferable one, in which the terminal vinylidene structure is chemically modified.

In a reference of Japanese Laid-Open Patent Publication No. H10-306128, the preparation method of polybutene containing a large quantity of terminal vinylidene structure, is disclosed. In this method, an olefin polymer having four carbon atoms containing 60 molar % or more of terminal vinylidene structure can easily be obtained by polymerizing isobutene singly, or isobutene with olefinic materials of butene-1 and butene-2 in the presence of boron tri-fluoride catalyst, because n-butene does not co-polymerize with isobutene. The molar percentage of terminal vinylidene can be identified by the integral value of peak area corresponding to olefins by means of $^{13}$C-NMR (cf. Japanese Laid-Open Patent Publication No. H10-306128 in detail).

A polybutene produced according to above mentioned method has a chemical structure that 80 molar % or more of the repeating units in the main chain is represented by the following formula (I). This polybutene has also long-term storage stability, because it scarcely has tertiary carbon atom that is liable to cause degradation.

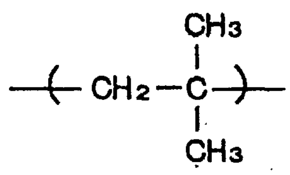

..... ( I )

For the purpose of industrial practice, it is efficient to obtain a reactive polybutene which is a reactive mono-olefin polymer containing predetermined molar % of functional groups through the process, for example, as disclosed in Japanese Laid-Open Patent Publication No. H10-306128, in which $C_4$-olefins containing isobutene, butene-1 and butene-2 are polymerized to obtain polybutene containing predetermined molar % or more of terminal vinylidene structure, which is followed by the reaction/conversion of a certain molar percent or more of the terminal vinylidene structure of the above $C_4$-olefin polymer. The content of functional groups of the reactive polybutene containing predetermined molar % of functional group can be determined by $^{13}$C-NMR method, $^{1}$H-NMR method or TLC (thin layer chromatography).

The reactive mono-olefin polymer (C) that has functional groups substantially at molecular terminals as the above reactive polybutene, is desirable because the liquid suspension mixture can be formed without difficulty. Although the reason for this is not clear, it is considered that a specific structure of reaction products of the reactive mono-olefin polymer (C) and the thermosetting resin (A) or the curing agent (B) may be related, in which the structure is formed by adding the thermosetting resin (A) (or the curing agent (B)) to the terminal of the long chain reactive mono-olefin polymer (C).

The reactive mono-olefin polymer (C) of the present invention must form a liquid suspension mixture, so that it is required to be dissolved into the thermosetting resin (A) and/or the curing agent (B) and the suspended state is preferably stable in the liquid suspension mixture. Accordingly, the reactive mono-olefin polymer (C) preferably has a number average molecular weight in the range of 300 to 6000. More preferable reactive mono-olefin polymer (C) is in liquid state at 23°C.

BRIEF DESCRIPTION OF DRAWING

Figure 1 shows an enlarged view of liquid suspension mixture obtained in Example of the present invention. Figure 2 shows an enlarged view of the phase structure of high impact strength thermosetting resin composition obtained in Example of the present invention. Figure 3 shows an enlarged view of phase structure of cured composition obtained by a prior art method.

BEST MODE FOR CARRYING OUT THE INVENTION

The present invention is described in more detail with reference to several examples.

[Reference Preparation Examples]

<Preparation of "reactive mono-olefin polymer">

In the preparation examples, the reactive mono-olefin polymer (C) is represented by epoxidized polybutene.
Used in Reference Preparation Examples 1 and 2 were commercially available LV-50 (trade name; produced by Nippon Petroleum Chemicals Co., Ltd.) and HV-100 (trade name; produced by Nippon Petroleum Chemicals Co., Ltd.) as reactant materials of polybutene for preparing epoxidized polybutene that are indicated in Table 1. In Reference Preparation Examples 3 to 6, highly reactive polybutene was used, which was obtained in accordance with the method disclosed in Japanese Laid-Open Patent Publication No. H10-306128 that was proposed by the present inventors. The highly reactive polybutene was also used in Comparative Example 1 and HV-300 (trade name; produced by Nippon Petroleum Chemicals Co., Ltd.) was used in Comparative Example 2.
Epoxidized polybutenes (in Reference Preparation Examples 1 to 6) were prepared by the reaction of peracid with raw materials of the foregoing 6 kinds of polybutenes with reference to the method as described in U.S. Patent No. 3,382,255.

Table 1

| Reference Preparation Examples | Raw Material for Epoxidized Polybetene | Mn (*1) |
|---|---|---|
| 1 | LV-50 | 430 |
| 2 | HV-100 | 980 |
| 3 | Highly reactive Polybutene | 370 |
| 4 | Highly reactive Polybutene | 650 |
| 5 | Highly reactive Polybutene | 1300 |
| 6 | Highly reactive Polybutene | 2300 |

*1: Number average molecular weight is measured by GPC (in terms of Polystyrene)

[Examples 1 to 12]

<Preparation of liquid suspension mixture before final curing reaction>

A flask having a variable speed stirrer, a reaction temperature indicator and a reactant dropping port, was placed in a thermostat bath.
Prescribed amounts of epoxidized polybutenes produced in Reference Preparation Examples 1 to 6 (shown in Table 2) were taken and prescribed amounts (also shown in Table 2) of thermosetting resin of Epikote #828, curing agent of MH-700 and curing accelerator of BDMA were fed together into the respective flasks. The mixtures were heated from the room temperature up to 100°C with stirring and the reaction were continued for subsequent two hours at 100°C
As a result, under any conditions of Examples 1 to 12, liquid suspension mixtures could be obtained. Although they were left to stand still for one month, none of phase separation was observed. The solution obtained in Example 5 was observed by an optical microscope, with which it was confirmed that the phase structure consists of particles of dispersed phase (2) that are dispersed in the continuous phase (1) as shown in Figure 1.

<Description of the commercial products used in Examples>

1) Epikote #828 (produced by Japan Epoxy Resins Co., Ltd.)
An epoxy resin mainly composed of bisphenol A type diglycidyl ether. Functional group (epoxy group) equivalent is about 190 g/eq.
2) MH-700 (produced by Shin Nihon Rika Co., Ltd.)
An acid anhydride type curing agent mainly comprising methylhexahydrophthalic anhydride. The functional group (acid anhydride group) equivalent is about 168 g/eq.
3) BDMA (reagent grade product of Tokyo Kasei Industry Co., Ltd.)
A curing accelerator mainly comprising benzyl dimethylamine.

Table 2

| Example | Reactive Monoolefine Polymer | Thermo-setting Resin | Curing Agent | Curing Accelerator |
|---|---|---|---|---|
| | Epoxidized Polybutene | Epikote #828 | MH-700 | BDMA |
| 1 | Reference Preparation Example 1: 9.5 g | 130.0 g (684 meq) | 4.5 g (27 meq) | 0.90 g |
| 2 | Reference Preparation Example 2 : 21.6 g | 130.0 g (684 meq) | 4.5 g (27 meq) | 0.90 g |
| 3 | Reference Preparation Example 3: 8.1 g | 130.0 g (684 meq) | 4.5 g (27 meq) | 0.90 g |
| 4 | Reference Preparation Example 4: 14.3 g | 130.0 g (684 meq) | 4.5 g (27 meq) | 0.90g |
| 5 | Reference Preparation Example 5: 28.6 g | 130.0 g (684 meq) | 4.5 g (27 meq) | 0.90 g |
| 6 | Reference Preparation Example 6: 50.6 g | 130.0 g (684 meq) | 4.5 g (27 meq) | 0.90 g |
| 7 | Reference Preparation Example 1: 9.5 g | 4.0 g (21 meq) | 65.9 g (392 meq) | 0.90 g |
| 8 | Reference Preparation Example 2: 21.6 g | 4.0 g (21 meq) | 65.9 g (392 meq) | 0.90 g |
| 9 | Reference Preparation Example 3: 8.1 g | 4.0 g (21 meq) | 65.9 g (392 meq) | 0.90 g |
| 10 | Reference Preparation Example 4: 14.3 g | 4.0 g (21 meq) | 65.9 g (392 meq) | 0.90 g |
| 11 | Reference Preparation Example 5: 28.6 g | 4.0 g (21 meq) | 65.9 g (392 meq) | 0.90 g |
| 12 | Reference Preparation Example 6: 50.6 g | 4.0 g (21 meq) | 65.9 g (392 meq) | 0.90 g |

[Comparative Examples 1 to 2, Comparative Examples 7 to 8]

In each Comparative Example, the same devices as those in the foregoing examples were used under the conditions as indicated in Table 3. Reaction temperature and time were same as those in the foregoing examples. In any cases, liquid suspension mixtures can also be obtained in the like manner as the foregoing examples, while any phase separation after one month was not observed, either. However, in mixtures of Comparative Examples 7 and 8, viscosities became extremely high without fluidity, so that they were not used practically.

Table 3

| Comparative Example | | Thermo-setting Resin | Curing Agent | Curing Accelerator |
|---|---|---|---|---|
| | Additional Component | Epikote #828 | MH-700 | BDMA |
| 1 | Highly Reactive Polybutene (Mn 1300): 28.6g | 130.0 g (684 meq) | 4.5 g (27 meq) | 0.90 g |
| 2 | HV-300 (Mn1300): 28.6g | 130.0 g (684 meq) | 4.5 g (27 meq) | 0.9.0 g |
| 7 | Reference Preparation Example 1: 9.5g | 130.0 g (684 meq) | 38.0 g (228 meq) | 0.90 g |
| 8 | Reference Preparation Example 5: 28.6g | 29.9 g (157 meq) | 65.9 g (392 meq) | 0.90 g |

[Examples 13 to 21, Comparative Examples 3 to 6]

<Examples of curing of epoxy resin and evaluation of final resin composition>

In examples, thermosetting resin compositions were represented by epoxy resin composition.

The epoxy resin compositions of the present invention were prepared through the following procedure. In Examples 1 to 6 and Comparative Examples 1 to 2, MH-700 was added to the liquid suspension mixture to supplement the shortage in the final amount of composition to adjust the equivalent ratio of functional group of curing agent/epoxy resin as shown in Table 4. Then these were stirred at room temperature to be uniformly mixed. Furthermore, 1 phr of BDMA was added to each mixture and then each epoxy resin composition was obtained after subjecting them through three step thermal histories of (1) 100°C for two hours, (2) 120°C for two hours and (3) 140°C for two hours.

In Comparative Example 5, the same weight of the existing material of modified acrylonitrile-butadiene rubber CTBN 1300X8 (produced by Ube Industries, Ltd.) was added, without the purpose to produce liquid suspension mixture of the present invention. In Comparative Example 6, a stress releasing material as a flexible component was not added at all. In both Comparative Examples, the equivalent ratio of epoxy resin and curing agent, amount of curing accelerator and thermal history were the same as those in Examples 13 to 21 and Comparative Examples 3 and 4.

Epoxy resin composition was evaluated by five items of flexibility, resistance to humidity, resistance to cracking, chemical resistance and thermal resistance. Each composition of these examples and comparative examples was molded into specimens suitable for each evaluation test.

<Evaluation Method >

Each evaluation method is described in the following.

1) Flexibility

Flexibility of cured composition was evaluated by three items of (1) Barcol hardness, (2) flexural yield strength and (3) flexural modulus test in accordance with JIS K 6911. In Barcol hardness test and flexural yield strength test, the values were represented by the average of five times' tests. In flexural modulus test, the average of ten times' tests was obtained.

2) Resistance to Humidity

Resistance to humidity was evaluated by the change in weight of cured specimen before and after soaking in boiling water for 10 hours. The test was done twice and the average of resultant values was obtained.

3) Resistance to Cracking

Resistance to cracking was measured using cured specimen, in which metal washers of different thermal conductivity were buried according to JIS C 2105 (Testing method of solventless liquid resin for electrical insulation). The result was calculated by the observation of average numbers of cracks of five specimens cooled from 150°C to 0°C.

4) Chemical Resistance

Cured specimen was soaked in a 10% aqueous solution of sodium hydroxide or n-heptane for three days. The changes in weight of specimens during the soaking were determined. The result was obtained by the average of two times' tests.

5) Thermal Stability

Heat distortion temperature (HDT) was measured in accordance with JIS K 6911. The thermal stability of cured composition was evaluated in terms of HDT, which was represented by the average of five times' tests.

6) Shrinkage Ratio

Volume shrinkage percentage was calculated by the following formula in accordance with JIS K 6911.

Volume shrinkage percentage

= (density after curing - density before curing)/(density after curing) × 100

Density before curing was obtained by extrapolation at zero hour on the values of density of each mixed composition measured at regular intervals from the beginning of mixing. In the case that reaction occurs during the raising of temperature, the density of mixture was calculated from the densities of respective components.

Density after curing was obtained by measuring the mass in silicone oil or in distilled water.

7) Ratio of Water Absorption

The ratio of water absorption was measured in accordance with JIS K 7114.

In Tables 4 and 5, the mixing conditions and evaluated physical data of epoxy resin compositions are shown.

Table 4

| Mixing Condition | | Example | | | | | | Comparative Ex. | | | |
|---|---|---|---|---|---|---|---|---|---|---|---|
| | | 13 | 14 | 15 | 16 | 17 | 18 | 3 | 4 | 5 | 6 |
| Curing Agent / EpoxyResin | MH700/ Epikote #828 (Ratio of Functional Group Equivalents) | 0.9 | 0.9 | 0.9 | 0.9 | 0.9 | 0.9 | 0.9 | 0.9 | 0.9 | 0.9 |

Table 4 (continued)

| Mixing Condition | | Example | | | | | | Comparative Ex. | | | |
|---|---|---|---|---|---|---|---|---|---|---|---|
| | | 13 | 14 | 15 | 16 | 17 | 18 | 3 | 4 | 5 | 6 |
| Flexible Component (*1) | Component of Example 1 | 17 | | | | | | | | | |
| | Component of Example 2 | | 17 | | | | | | | | |
| | Component of Example 3 | | | 17 | | | | | | | |
| | Component of Example 4 | | | | 17 | | | | | | |
| | Component of Example 5 | | | | | 17 17 | | | | | |
| | Component of Example 6 | | | | | | 17 | | | | |
| | Component of Comparative Example 1 | | | | | | | 17 | | | |
| | Component of Comparative Example 2 | | | | | | | | 17 | | |
| | CTBN 1300×8 | | | | | | | | | 17 | |
| | No Addition | | | | | | | | | | 0 |
| Curing (*1) Accelerator | BDMA | 1 | 1 | 1 | 1 | 1 | 1 | 1 | 1 | 1 | 1 |
| Evaluation | | | | | | | | | | | |
| | (1) Barcol Hardness | 0 | 0 | 0 | 0 | 0 | 0 | 0 | 0 | 13 | 37 |
| Flexibility | (2) Flexural Yield Strength($kg/mm^2$) | 6.4 | 5.3 | 3.7 | 5.9 | 5.1 | 3.6 | 4.7 | 4.5 | 6.8 | 12.7 |
| | (3) Flexural Modulus($kg/mm^2$) | 212 | 189 | 237 | 214 | 177 | 159 | 147 | 142 | 187 | 307 |
| Resistance to Humidity | Resistance to Boiling Water | 1.1 | 1.0 | 1.3 | 1.0 | 1.0 | 1.0 | 1.0 | 1.0 | 1.1 | 1.0 |
| Resistance to Cracking | Average Number of Cracks | 1 | 1 | 0 | 0 | 0 | 0 | 3 | 4 | 0 | 7 |
| Chemical Resistance | Resistance to 10% NaOH Soln. | 0.2 | 0.2 | 0.2 | 0.2 | 0.2 | 0.3 | 0.2 | 0.2 | 0.3 | 0.2 |
| | Resistance to n-Heptane | 0.0 | -0.1 | -0.1 | -0.1 | -0.2 | -0.3 | -0.2 | -0.2 | 0.1 | -0.1 |
| Thermal Analysis | HDT (°C) | 118 | 128 | 110 | 125 | 129 | 130 | 128 | 127 | 102 | 133 |

*1: Numerals in Table indicate percentages of the reactive mono-olefin polymer or added component in the cured composition.

Table 5

| Mixing Condition | | Example | | | | Comparative Ex. |
|---|---|---|---|---|---|---|
| | | 17 | 19 | 20 | 21 | 6 |
| Curing Agent / Epoxy Resin | MH700/ Epikote #828 (Ratio of Functional Group Equivalent) | 0.9 | 0.9 | 0.9 | 0.9 | 0.9 |
| Flexible Component (*1) | Component of Component of Example 5 | 17 | 5 | 10 | 24 | 0 |
| Curing (*1) Accelerator | BDMA | 1 | 1 | 1 | 1 | 1 |
| Evaluation | | | | | | |
| Flexibility | (2) Flexural Yield Strength (kg/ $mm^2$) | 5.1 | 7.4 | 5.9 | 4.0 | 12.7 |
| | (3) Flexural Modulus (kg/$mm^2$) | 177 | 258 | 224 | 147 | 307 |
| Resistance to Humidity | Resistance to Boiling Water | 1.0 | 1.0 | 0.9 | 1.0 | 1.0 |
| Chemical Resistance | Resistance to 10% NaOH Solution | 0.2 | 0.2 | 0.2 | 0.2 | 0.2 |
| | Resistance to n-Heptane | -0.2 | -0.1 | -0.1 | -0.5 | -0.1 |
| Thermal Analysis | HDT (°C) | 129 | 136 | 134 | 130 | 133 |
| Curing Characteristics | Shrinkage Ratio (%) | 0.3 | - | 0.8 | 0.0 | 2.0 |
| | Ratio of Water Absorption | 0.1 | - | 0.1 | 0.1 | 0.1 |

*1: Numerals in Table indicate percentages of the reactive mono-olefin polymer or added component in the cured composition.

<Observation of Phase Structure>

The phase structures of examples and comparative examples were observed by transmission electron microscope (TEM) (tradename: JEM-1010, made by JEOL Ltd.). Specimens were stained with ruthenium oxide and they were observed at 100 kV of applied voltage. As a result, it was judged that the stained phase mainly comprises the material of polybutene. The observed result of Example 17 is shown in Figure 2 and Comparative Example 3 is shown in Figure 3. In the observation of Example 17, it was observed that dispersed phases (2) exist in continuous phase (1), including finer dispersed phase (2-1) within the dispersed phase. It was also observed that interfacial phase (3) exists at a boundary of the continuous phase (1) between the dispersed phase (2). It was confirmed that both of Phase Structure I and Phase Structure II of the present invention are formed. In Comparative Example 3, it was confirmed that only the sea-island structure of dispersed phase (2) exists in the continuous phase (1).

[Comparative Example 9]

It was tried to obtain the same high impact strength thermosetting resin composition as in Example 13 containing the same compounding ratios of constituent materials as the final product by feeding all components at one time without the step of forming liquid suspension mixture described in Example 1. The reaction time and temperature were made the same as those in the above-mentioned Example. However, in this cured composition, it was confirmed that this method is not practical because the phase separation of cured resin composition containing thermosetting resin or further with the curing agent, from the reactive mono-olefin polymer was observed.

[Examples 100 to 102]

<Preparation of suspended mixture before final curing>

The same reaction apparatus as those in Examples 1 to 12 were employed. As shown in Table 6, predetermined amount of a thermosetting resin of YDCN-702 (produced by Toto Kasei Co., Ltd.), a curing agent of MH-700 (produced by Shin Nihon Rika Co., Ltd.) and a curing accelerator of BDMA were supplied simultaneously to predetermined amount of epoxidized polybutene of Reference Preparation Example 5 in a flask. The temperature of the mixtures

was then raised to 120°C from room temperature with mixing and the reaction was carried out for 30 minutes at 120°C. Consequently, in any conditions of Examples 100 to 102, liquid mixtures with suspended state were obtained at the time of reaction. The mixtures turned to solid powder at room temperature. The mixtures did not cause the phase separation after one month.

<Description of commercial products used for examples>

1) YDCN-702 (produced by Toto Kasei Co., Ltd.)
YDCN-702 is epoxy resin which is mainly comprised of o-cresol type. The functional group (epoxy group) equivalent is about 205 g/eq.
2) MH-700 (produced by Shin Nihon Rika Co., Ltd.)
MH-700 is an acid anhydride-type curing agent, which is mainly composed of methylhexahydrophthalic anhydride. The functional group (acid anhydride) equivalent is about 168 g/eq.
3) BDMA (reagent; produced by Tokyo Kasei Industry Co., Ltd.)
BDMA is a curing accelerator which is mainly comprised of benzyl dimethylamine.

Table 6

| Example | Reactive Mono-olefin Polymer | Thermosetting Resin | Curing Agent | Curing Accelerator |
|---|---|---|---|---|
| | Epoxidized polybutene | YDCN-702 | MH-700 | BDMA |
| 100 | Preparation Example for reference 5: 10.6g | 100.0g (488 meq) | 3.8g (23 meq) | 0.10 g |
| 101 | Preparation Example for reference 5: 21.2g | 100.0g (488 meq) | 3.8g (23 meq) | 0.10 g |
| 102 | Preparation Example for reference 5: 29.4g | 100.0g (488 meq) | 3.8g (23 meq) | 0.10 g |

[Examples 200 to 202, Comparative Examples 100]

<Preparation of cured phenol resin composition and evaluation>

Phenol resin compositions of the present invention were produced through the following procedure.

Predetermined amount of novolak-phenol curing agent TD-2131 (produced by DIC Co., Ltd.) was added to each suspended mixture produced in Examples 100 to 102 with adjusting the final amount ratio of composition as shown in Table 7. Then, 1 phr of TPP (triphenyl phosphine) was added to the mixture as a curing accelerator respectively. Therafter, phenol resin compositions were obtained after being mixed into uniform state by Plastmill (manufactured by Toyo Seiki Co., Ltd.) at 120° C.

In Comparative Example 100, no stress releasing material was added. Also in this case, the same conditions were employed such as the equivalent ratio of o-cresol type epoxy resin to novolak-phenol curing agent, the amount of curing accelerator and the mixing method under heating.

Phenol resin compositions were evaluated with two items of flexibility and thermal stability. Each composition of these Examples and Comparative Example 100 was molded by hot press into suitable specimens for each evaluation test.

<Evaluating Method>

Each evaluating method is described in the following.

1) Flexibility

Flexibility was evaluated by two items of (1) flexural yield strength test and (2) flexural modulus test in accordance with JIS K 6911. Each value was calculated from the average of five times' test.

2) Thermal stability

Thermal stability of cured composition was evaluated by heat distortion temperature (HDT) in accordance with JIS K 6911. It was calculated from the average of five times'test.

The mixing conditions and evaluated results of each phenol resin composition were shown in Table7.

Table 7

| Mixing Condition | | Example | | | Comparative Example |
|---|---|---|---|---|---|
| | | 200 | 201 | 202 | 100 |
| Curring Agent / Epoxy Resin | TD2131/ YDCN-702 (Equivalent Ratio of Functional Group) | 1.0 | 1.0 | 1.0 | 1.0 |
| Flexible Component (*1) | Component of Example 100 | 6 | | | |
| | Component of Example 101 | | 12 | | |
| | Component of Example 102 | | | 18 | |
| | No Addition | | | | 0 |
| Curing (*1) Accelerator | TPP | 1 | 1 | 1 | 1 |
| Evaluation | | | | | |
| Flexibility | (2) Flexural Yield 2 Strength ($kg/mm^2$) | 6.4 | 5.9 | 4.5 | 7.7 |
| | (3) Flexural Modulus ($kg/mm^2$) | 274 | 259 | 237 | 295 |
| Thermal Analysis | HDT (°C) | 152 | 150 | 149 | 152 |

*1: Numerals in Table indicate percentages of epoxidized polybutene to total amount of composition.

< Observation of Phase Structure>

Each phase structure of the foregoing examples were observed by TEM in the same way as the epoxy resin composition. In all examples, it was confirmed that the Phase Structure II of the present invention was formed in all examples.

INDUSTRIAL APPLICABILITY

In thermosetting resin composition which is produced by curing a composition composed of thermosetting resin, curing agent and reactive mono-olefin polymer, a preparing method of the present invention enables to form sea-island structure consisting of continuous phase (1) and dispersed phase (2), including a plurality of finer dispersed phases (2-1) within the dispersed phase and/or at least one interfacial phase (3) which surrounds the dispersed phase (2). The continuous phase (1) is mainly composed of cured composition containing a thermosetting resin, or further component of a curing agent, and the dispersed phase is mainly composed of reactive mono-olefin polymer. It was confirmed that the formation of these phase structure enables to resolve the problem of thermosetting resin composition.

**Claims**

1. An impact resistant thermosetting resin composition having a phase structure of a sea-island structure composed of a continuous phase (1) and dispersed phases (2), said continuous phase (1) is mainly composed of a cured composition containing thermosetting resin and said dispersed phases (2) are mainly composed of a reactive mono-olefin polymer having functional groups which can react with said thermosetting resin, and furthermore, a plurality of finer dispersed phases (2-1) exist in said dispersed phases (2) and/or interfacial phases (3) of at least one layer surround said dispersed phases (2).

2. In a method for preparing an impact resistant thermosetting resin composition, which is produced by curing a composition composed of a thermosetting resin (A), a curing agent (B) and a reactive mono-olefin polymer (C)

which is chemically modified with functional groups being reactive with said thermosetting resin (A) or said curing agent (B), said thermosetting resin composition having a phase structure of a sea-island structure mainly composed of a continuous phase (1) and dispersed phases (2) including a plurality of finer dispersed phases (2-1) within said dispersed phases (2) and/or at least one layer of interfacial phases (3) surrounding said dispersed phases (2),

the improvement in said preparation method which is **characterized in that** said method includes a step to produce a liquid suspension mixture of the reactive mono-olefin polymer (C) and the thermosetting resin (A) and/or a further component of the curing agent (B).

**3.** The method for preparing an impact resistant thermosetting resin composition according to claim 2, wherein the liquid suspension mixture contains 1 to 200 parts by mass of the reactive mono-olefin polymer (C) relative to 100 parts by mass of the thermosetting resin (A) in the case that the curing agent (B) is not contained.

**4.** The method for preparing an impact resistant thermosetting resin composition according to claim 2, wherein the liquid suspension mixture contains the thermosetting resin (A), the curing agent (B) and the reactive mono-olefin polymer (C), and 1 to 100 parts by mass of the reactive mono-olefin polymer (C) is used relative to 100 parts by mass of components (A) + (B), in which the ratio of functional group equivalent (g/eq.) of (A)/(B) is 5 or more.

**5.** The method for preparing an impact resistant thermosetting resin composition according to claim 2, wherein the liquid suspension mixture contains the thermosetting resin (A), the curing agent (B) and the reactive mono-olefin polymer (C), and 1 to 100 parts by mass of the reactive mono-olefin polymer (C) is used relative to 100 parts by mass of components (A) + (B), in which the ratio of functional group equivalent (g/eq.) of (A)/(B) is 0.2 or less.

**6.** The method for preparing an impact resistant thermosetting resin composition according to claim 2, wherein the thermosetting resin (A) is an epoxy resin or a phenol resin.

**7.** The method for preparing an impact resistant thermosetting resin composition according to any one of Claims 2 to 6, wherein the functional group of said reactive mono-olefin polymer (C) is at least one member selected from the group consisting of the following (a) to (f):

(a) oxirane group,
(b) hydroxyl group,
(c) acyl group,
(d) carboxyl group (including acid anhydride group),
(e) amino group, and
(f) isocyanate group.

**8.** The method for preparing an impact resistant thermosetting resin composition according to any one of Claims 2 to 7, wherein 80 molar % or more of the repeating unit in the main chain of the olefin polymer in said reactive mono-olefin polymer (C) is represented by the following formula (I).

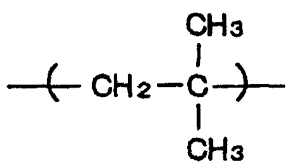

····· ( I )

**9.** The method for preparing an impact resistant thermosetting resin composition according to any one of Claims 2 to 8, wherein the functional groups of said reactive mono-olefin polymer is formed substantially at the terminal ends of said molecules.

**10.** The method for preparing an impact resistant thermosetting resin composition according to any one of claim 2 to 9, wherein the reactive mono-olefin polymer has a number average molecular weight in the range of 300 to 6000.

**11.** The method for preparing an impact resistant thermosetting resin composition according to any one of Claims 2 to 10, wherein the reactive mono-olefin polymer is in a liquid state at 23 °C.

**12.** A liquid suspension mixture which contains a thermosetting resin (A) and a reactive mono-olefin polymer (C) being modified by functional groups that are reactive with said thermosetting resin (A) and which does not contain a curing agent (B), wherein the liquid suspension mixture is composed of 1 to 200 parts by mass of said reactive mono-olefin polymer(C) relative to 100 parts by mass of said thermosetting resin (A).

**13.** A liquid suspension mixture which contains a thermosetting resin (A), a curing agent (B) and a reactive mono-olefin polymer (C) being modified by functional groups that are reactive with the thermosetting resin (A) or the curing agent (B), wherein the liquid suspension mixture is composed of 1 to 100 parts by mass of the reactive mono-olefin polymer (C) relative to 100 parts by mass of the components (A) + (B) and the ratio of functional group equivalent (g/eq.) as (A)/(B) is in the range of 5 or more.

**14.** A liquid suspension mixture which contains a thermosetting resin (A), a curing agent (B) and a reactive mono-olefin polymer (C) being modified by functional groups that are reactive with the thermosetting resin (A) or the curing agent (B), wherein the liquid suspension mixture is composed of 1 to 100 parts by mass of the reactive mono-olefin polymer (C) relative to 100 parts by mass of the components (A) + (B) and the ratio of functional group equivalent (g/eq.) as (A)/(B) is in the range of 0.2 or less.

FIG. 1

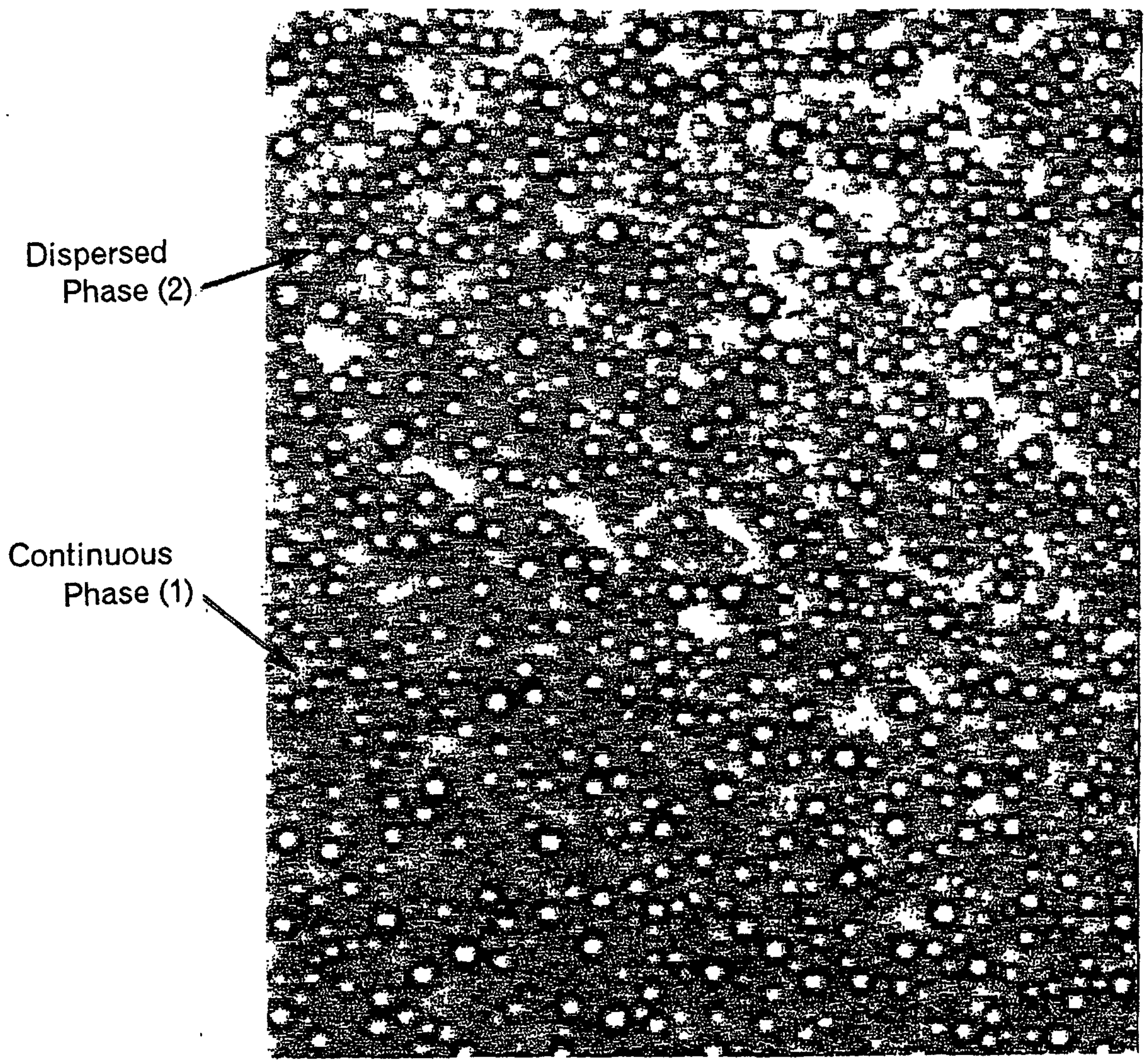

FIG. 2

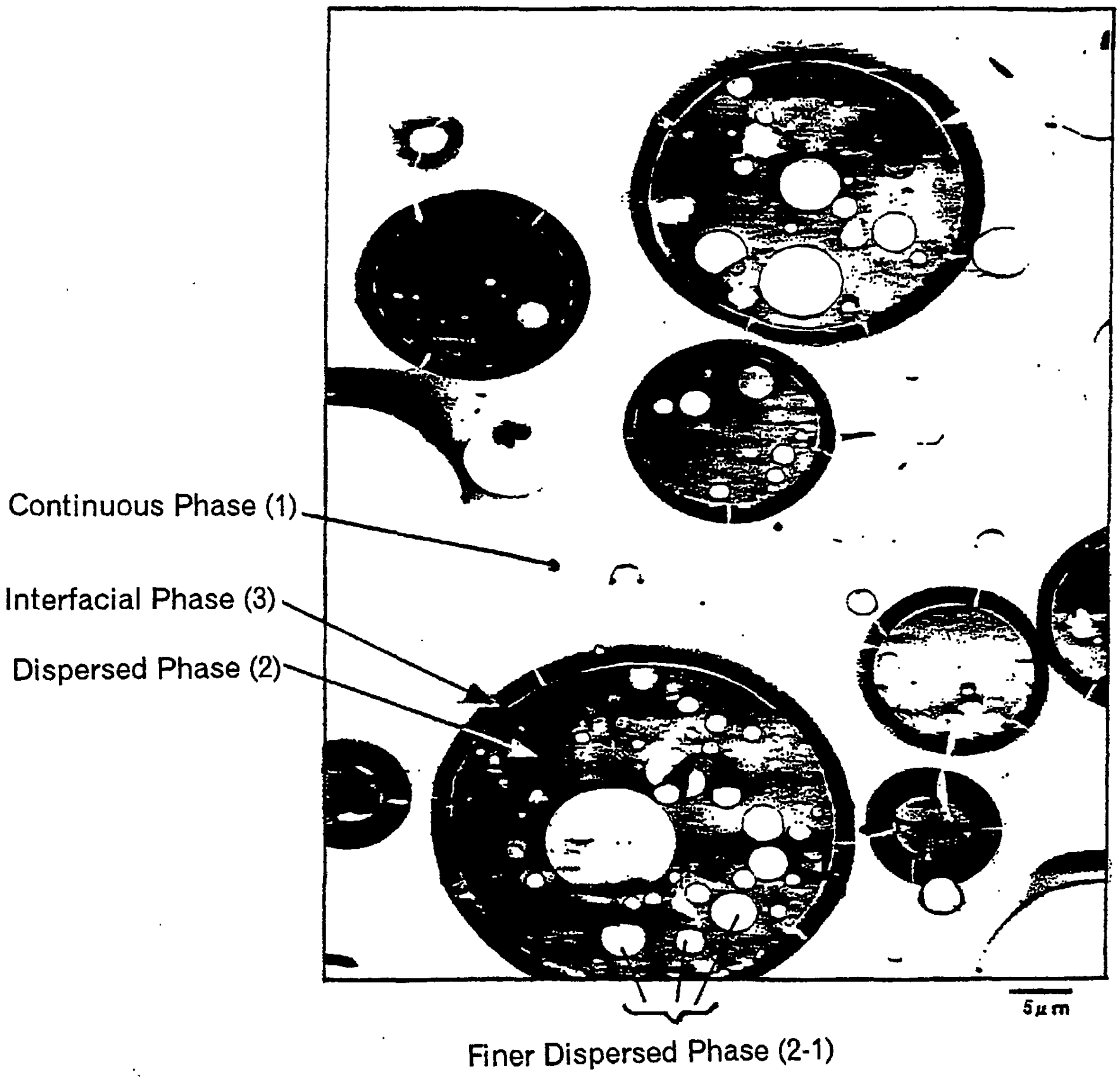
Continuous Phase (1)
Interfacial Phase (3)
Dispersed Phase (2)
5μm
Finer Dispersed Phase (2-1)

FIG. 3

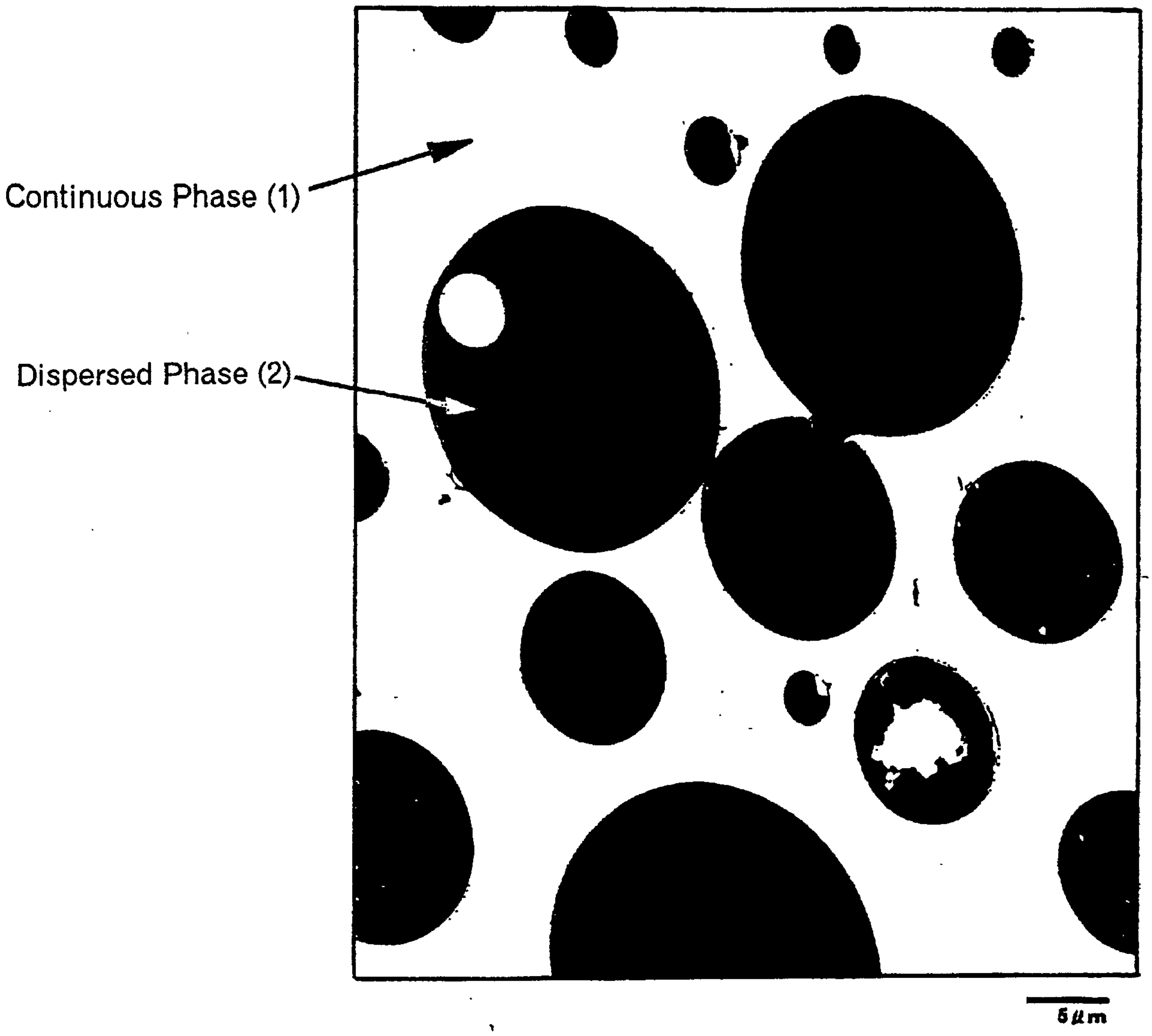

## INTERNATIONAL SEARCH REPORT

International application No.
PCT/JP02/05114

A. CLASSIFICATION OF SUBJECT MATTER
Int.Cl$^7$ C08L101/00, C08L23/30, C08L63/00

According to International Patent Classification (IPC) or to both national classification and IPC

B. FIELDS SEARCHED

Minimum documentation searched (classification system followed by classification symbols)
Int.Cl$^7$ C08L101/00-12, C08L23/30, C08L63/00-10

Documentation searched other than minimum documentation to the extent that such documents are included in the fields searched

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| A | EP 415749 A2 (Amoco Corp.), 06 March, 1991 (06.03.91), Claims & US 5084531 A Claims & US 5225486 A | 1-14 |
| A | JP 2001-89638 A (Toshiba Chemical Corp.), 03 April, 2001 (03.04.01), Claims (Family: none) | 1-14 |
| A | JP 6-306144 A (Nippon Oil Co., Ltd.), 01 November, 1994 (01.11.94), Claims (Family: none) | 1-14 |

[x] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
12 August, 2002 (12.08.02)

Date of mailing of the international search report
03 September, 2002 (03.09.02)

Name and mailing address of the ISA/
Japanese Patent Office

Facsimile No.

Authorized officer

Telephone No.

Form PCT/ISA/210 (second sheet) (July 1998)

INTERNATIONAL SEARCH REPORT

International application No.
PCT/JP02/05114

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-41363 A (Nippon Petrochemicals Co., Ltd.), 15 February, 1994 (15.02.94), Claims (Family: none) | 1-14 |
| A | JP 7-220536 A (Hitachi Cable, Ltd.), 18 August, 1995 (18.08.95), Claims (Family: none) | 1-14 |
| A | JP 6-116363 A (Nippon Petrochemicals Co., Ltd.), 26 April, 1994 (26.04.94), Claims (Family: none) | 1-14 |
| A | JP 6-116362 A (Nippon Petrochemicals Co., Ltd.), 26 April, 1994 (26.04.94), Claims (Family: none) | 1-14 |

Form PCT/ISA/210 (continuation of second sheet) (July 1998)